# EUROPEAN PATENT SPECIFICATION

(11) **EP 4 485 523 B1**
(45) Date of publication and mention of the grant of the patent: **11.03.2026**
(21) Application number: 24185186.4
(22) Date of filing: 28.06.2024
(51) Int. Cl.: H01L 23/00, H01L 23/373, H01L 25/07, H01L 23/31, H01L 23/495, H01L 23/498

(54) **INTERCONNECT PACKAGE AND POWER MODULE**
VERBINDUNGSGEHÄUSE UND LEISTUNGSMODUL
BOÎTIER D'INTERCONNEXION ET MODULE DE PUISSANCE

(30) Priority: 30.06.2023 CN 202310809702
(43) Date of publication of application: 01.01.2025
(73) Proprietor: Shenzhen STS Microelectronics Co., Ltd., Shenzhen 518048 (CN)
(72) Inventor: CHEN, Qiao, Shenzen 518040 (CN); ZHENG, Nan Nan, Shenzen 518038 (CN); ZHANG, Zhi Chang, Shenzen 518040 (CN)
(74) Representative: Casalonga

(56) References cited:
- US-A1- 2008 305 582
- US-A1- 2018 114 781
- US-A1- 2020 105 677
- US-A1- 2021 313 282

## Description

### FIELD

Embodiments of the present disclosure generally relate to the field of power electronics, and more specifically to an interconnect package, a method of forming the interconnect package, and a power module employing the interconnect package.

### BACKGROUND

In recent years, vigorous development of electric vehicles has caused update iterations of power semiconductor technologies. Currently, power modules based on power devices are widely used in the field of power electronics due to their advantages such as a high switching speed, low loss and high thermal stability. The power devices hold a core position in power electronic systems, and their reliability is the most important factor for determining the safe operation of the whole system.

The power device achieves interconnection to an external circuit through the package. In conventional packaging processes for power modules, interconnection and packaging are performed by wire bonding or by pouring a filler material such as a resin. However, the filler material such as silicone gel might age more rapidly over time or through cyclic testing, thereby causing degradation in moisture and oxidation prevention and even insulation performance, and greatly reducing the reliability of the interconnection of lead wires in the power module.

Documents US 2020/105677 A1, US 2021/313282 A1 and US 2008/305582 A1 disclose various examples of interconnect packages.

### SUMMARY

In view of the above problems, embodiments of the present disclosure are intended to providing a solution for improving reliability of an interconnect package.

According to a first aspect of the present disclosure, there is provided an interconnect package. The interconnect package comprises a first insulating layer, a source connecting portion disposed on a surface of the first insulating layer and adapted to electrically connect a source pad to a substrate, a second insulating layer, and a gate connecting portion disposed between the first insulating layer and the second insulating layer and adapted to electrically connect a gate pad to the substrate. The second insulating layer has a plurality of gate openings and a plurality of source openings running therethrough and wherein a first surface of the second insulating layer is configured to attach to a surface of the first insulating layer such that a plurality of portions of the source connecting portion are exposed from the plurality of source openings on a second surface of the second insulating layer opposite the first surface, and such that a plurality of portions of the gate connecting portion are exposed from the plurality of gate openings on the second surface of the second insulating layer.

In some embodiments of the first aspect, the plurality of portions of the gate connecting portion exposed from bottom ends of the plurality of gate openings, and conductive traces not exposed from the plurality of gate openings are formed by depositing a conductive film on the first surface of the second insulating layer, wherein the plurality of portions of the gate connecting portion comprise a gate pad connecting portion for coupling with the gate pad and a gate substrate connecting portion for coupling with the substrate, and wherein the conductive trace electrically connects the gate pad connecting portion with the gate substrate connecting portion.

In some embodiments of the first aspect, the source connecting portion is formed by a conductive sheet, wherein the plurality of portions of the source connecting portion comprise a source pad connecting portion for coupling with the source pad, and a source substrate connecting portion for coupling with the substrate, and wherein the source pad connecting portion is electrically connected with the source substrate connecting portion via a portion of the conductive sheet not exposed from the plurality of source openings.

In some embodiments of the first aspect, the source pad connecting portion and the source substrate connecting portion are formed by patterning the conductive sheet, and wherein a thickness of the source pad connecting portion is less than that of the source substrate connecting portion and greater than that of the portion of the conductive sheet.

In some embodiments of the first aspect, the thickness of the source pad connecting portion is less than a depth of the plurality of source openings.

In some embodiments of the first aspect, the thickness of the source pad connecting portion is greater than or equal to the depth of the source opening.

In some embodiments of the first aspect, the source substrate connecting portion is electrically connected to the substrate through a conductive gasket.

In some embodiments of the first aspect, the gate substrate connecting portion is coupled to the substrate through a conductive gasket.

In some embodiments of the first aspect, a second conductive film is deposited at the bottom ends of the plurality of gate openings such that a portion of the second conductive film on the gate substrate connecting portion has a thickness greater than that of a portion of the second conductive film on the gate pad portion.

According to a second aspect of the present disclosure, there is provided a method of forming an interconnect package. The method comprises: forming a source connecting portion on a surface of a first insulating layer, the source connecting portion being adapted to electrically connect a source pad to a substrate; forming a second insulating layer, the second insulating layer having a plurality of gate openings and a plurality of source openings running therethrough; forming a gate connecting portion between the first insulating layer and the second insulating layer, the gate connecting portion being adapted to electrically connect a gate pad to the substrate; and attaching a first surface of the second insulating layer to a surface of the first insulating layer such that a plurality of portions of the source connecting portion are exposed from the plurality of source openings on a second surface of the second insulating layer opposite the first surface, and such that a plurality of portions of the gate connecting portion are exposed from the plurality of gate openings on a second surface of the second insulating layer.

According to a third aspect of the present disclosure, there is provided a power module. The power module comprises: a substrate; a die disposed on the substrate and including a source pad and a gate pad; the interconnect package according to the first aspect of the present disclosure which covers the die and is used for electrically connecting the source pad and the gate pad of the die to the substrate, respectively.

The Summary is provided to introduce a selection of concepts in a simplified form that are further described below in the Detailed Description. This Summary is not intended to identify key features or essential features of the present disclosure, nor is it intended to limit the scope of the present disclosure. Other features of the present disclosure will become readily apparent from the following description.

### BRIEF DESCRIPTION OF THE DRAWINGS

The above and other features, advantages, and aspects of embodiments of the present disclosure will become more apparent by reference to the following detailed description with reference to the accompanying drawings. In the drawings, like or similar reference numerals refer to the same or similar elements,
FIG. 1A illustrates a top view of a conventional power module interconnected by wire bonding.
FIG. 1B illustrates a perspective view of the power module shown in FIG. 1A.
FIG. 1C illustrates an electron microscope image of a wire defect caused by the aging of a package of the power module shown in FIG. 1A.
FIG. 2A illustrates a perspective view of a power device not interconnected and packaged yet.
FIG. 2B illustrates a perspective view of the power device shown in FIG. 2A with an interconnect package attached.
FIG. 2C illustrates a perspective view of an interconnect package according to an embodiment of the present disclosure.
FIG. 3A illustrates a top view of a portion of a power device with an interconnect package attached according to an embodiment of the present disclosure.
FIG. 3B illustrates a cross-sectional view taken in the direction A-A' of the interconnect package and power device shown in FIG. 3A.
FIG. 3C illustrates a cross-sectional view taken in direction B-B' of the interconnect package and power device shown in FIG. 3A.
FIG. 4 illustrates an exploded view of an interconnect package according to a first embodiment of the present disclosure.
FIG. 5 illustrates an enlarged partial perspective view of the interconnect package shown in FIG. 4.
FIG. 6 illustrates a scanning electron microscope (SEM) image of a conductive film according to an embodiment of the present disclosure.
FIG. 7 illustrates an exploded view of an interconnect package according to a second embodiment of the present disclosure.
FIG. 8A and FIG. 8B show cross-sectional views of an interconnect package according to a second embodiment of the present disclosure taken in directions A-A' and B-B'in FIG. 3A, respectively.
FIG. 9 illustrates an enlarged partial perspective view of the interconnect package shown in FIG. 7.
FIG. 10 illustrates an exploded view of an interconnect package according to a third embodiment of the present disclosure.
FIG. 11 illustrates an exploded view of an interconnect package according to a fourth embodiment of the present disclosure.
FIG. 12 illustrates an enlarged partial perspective view of the interconnect package shown in FIG. 11.
FIG. 13A and FIG. 13B illustrate cross-sectional views of the interconnect package shown in FIG. 12 taken in directions A-A' and B-B', respectively.
FIG. 14 illustrates a flow diagram of a process 600 for preparing an interconnect package 20 according to an embodiment of the present disclosure.

### DETAILED DESCRIPTION OF EMBODIMENTS

Hereinafter, embodiments of the present disclosure will be described in more detail with reference to the accompanying drawings. While certain embodiments of the present disclosure have been illustrated in the accompanying drawings, it is to be understood that the present disclosure may be embodied in various forms and should not be construed as being limited to the embodiments set forth herein; rather, these embodiments are provided to enable thorough and complete understanding of the present disclosure. It should be understood that the drawings and embodiments of the present disclosure are for illustrative purposes only and are not intended to limit the scope of the present disclosure.

In the depictions of the embodiments of the present disclosure, the term "include" and other similar terms are to be construed as open-ended terms, i.e., "include but not limited to". The term "based on" should be understood as "based at least in part on". The terms "one embodiment" or "the embodiment" should be understood to mean "at least one embodiment". The terms "first", "second" and the like may refer to different or identical objects. Other explicit and implicit definitions may also be included below.

Directional terms, such as "top", "bottom", "above", "below", "front", "rear", "head", "tail", "over" and "beneath", and the like, may be used with reference to the directions of the described figures and/or elements. Because embodiments may be oriented in a variety of different orientations, such directional terms are used for purposes of illustration and not intended to be limiting. In some examples, directional terms may be exchanged with equivalent directional terms based on the orientations of the embodiments so long as the general directional relationship between the elements and their general purposes are maintained.

In the present disclosure, expressions including numbers (such as "first", "second", etc.) may modify various elements. However, these elements are not limited to the above expressions. For example, the above expressions do not limit the order and/or importance of the elements. The above expressions are intended only to distinguish one element from other elements.

It will be understood that when an element is referred to as being "connected" or "coupled" to another element, it may be directly connected or coupled to the other element or connected or coupled via an intermediate element. In contrast, when an element is referred to as being "directly connected" or "directly coupled" to another element, there is not an intermediate element. Other words used to describe relationships between elements should be interpreted in a similar manner (e.g., "between" versus "directly between", "adjacent" versus "directly adjacent", etc.).

In the embodiments described herein or shown in the figures, any direct electrical connection or coupling (i.e., any connection or coupling without additional intermediate elements) may also be implemented by indirect connection or coupling (i.e., connection or coupling with one or more additional intermediate elements), and vice versa, so long as the general purpose of the connection or coupling is substantially maintained.

As described above, conventional power module packaging processes perform encapsulation by wire bonding interconnection and pouring silicone gel. However, in some cases, aging of the silicone gel over time will cause reduction of moisture and oxidation prevention, which greatly reduces the interconnection reliability of the wires in the power module.

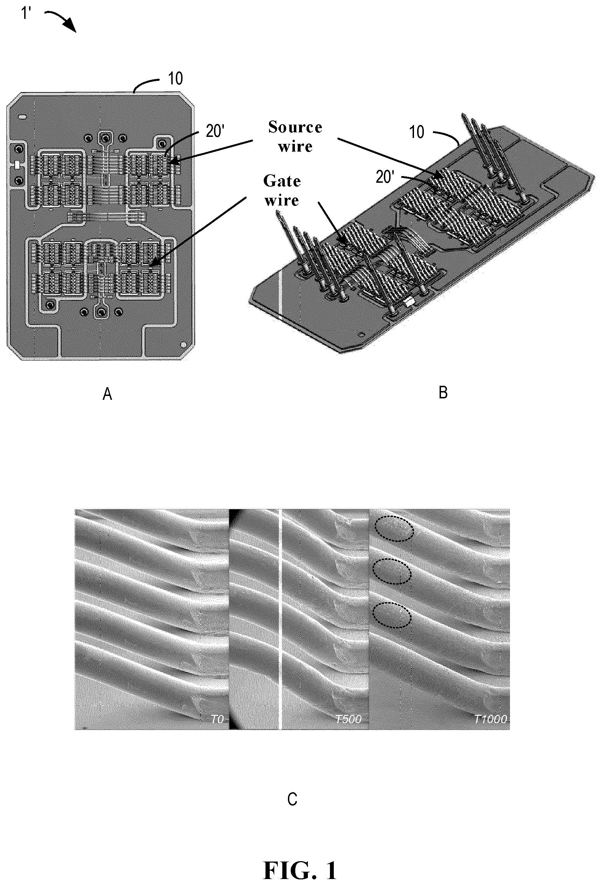

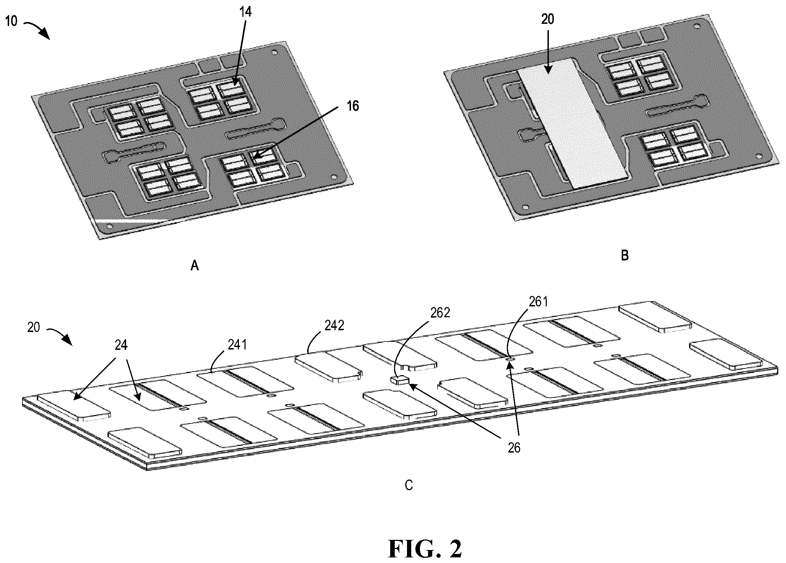

Specifically, FIG. 1A and FIG. 1B respectively show a top view and a perspective view of a conventional power module 1' interconnected by wire bonding. As shown in FIG. 1A and FIG. 1B, the power module 1' comprises a power device 10, and wires that electrically connect a source pad and a gate pad (described below with reference to FIG. 2) of the power device 10 to a substrate (described below with reference to FIG. 2). The wires 20' comprise a source wire and a gate wire, as indicated by the arrows in the figure.

After interconnection via wire bonding, resin is poured to the power module for encapsulation to isolate from an external environment to enable the power chip to operate reliably. In the field of power electronics, in addition to the properties and characteristics of the device, reliability becomes the most important quality assessment means and target of the power module. As previously mentioned, the performance of the power device requires the support of the package, so a weak point of the device package is exposed in advance by accelerating aging to some degree during reliability testing.

FIG. 1C illustrates an electron microscope image of defect spots appearing on wires after a conventional package is subjected to a thermal cycle test, as indicated by dotted line boxes. In the case shown in FIG. 1C, defects in the metal wires might cause problems such as wire breakage, cross-lapping, etc. which degrade the performance of the device.

According to an embodiment of the present disclosure, there is provided an interconnect package which exhibits an excellent performance in a reliability test process and greatly improves the reliability of a power module by performing the interconnect packaging by using multiple layers of insulating film and in a non-wire bonding manner. Embodiments of the present disclosure are described in detail below with reference to the figures. It should be appreciated that this is for illustrative purposes only and is not intended to limit the scope of the present invention in any way.

FIG. 2A illustrates a perspective view of the power device 10. FIG. 2B illustrates a perspective view of a portion of the power device 10 shown in FIG. 2A with an interconnect package 20 attached. In some embodiments, the power device 10 in FIG. 2A and Fig. 2B has a structure the same as or similar to the power device of FIG. 1. As shown in FIG. 2A, the power device 10 comprises a substrate 12 and a plurality of dies (not shown) formed on the substrate 12. Each die comprises a plurality of source pads 14 and gate pads 16.

In FIG. 2B, the interconnect package 20 covers and is attached to the power device 10 by a sintering process to form a circuit loop while performing package protection for the power device. The sintering process is typically accomplished by sintering a conductive paste, also known as a sintering paste. In some embodiments, the conductive pastes are classified into a carbon paste (graphite conductor), a metal paste (gold powder, silver powder, copper powder, or silver copper alloy), and a modified ceramic paste according to fillers therein. It should be appreciated that in other embodiments, interconnection package 20 may be attached to the power device 10 in any other manner, and the attachment manners are not limited in the present disclosure.

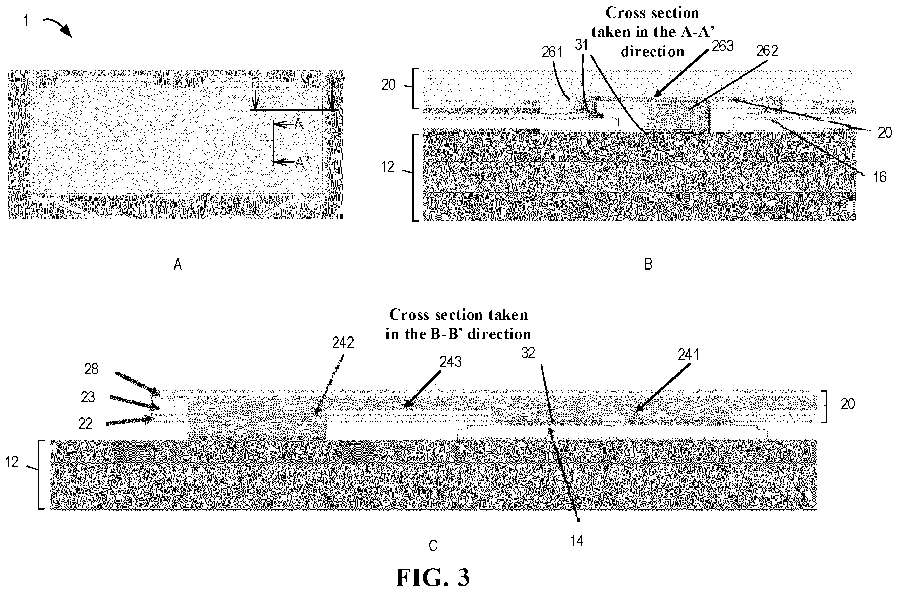

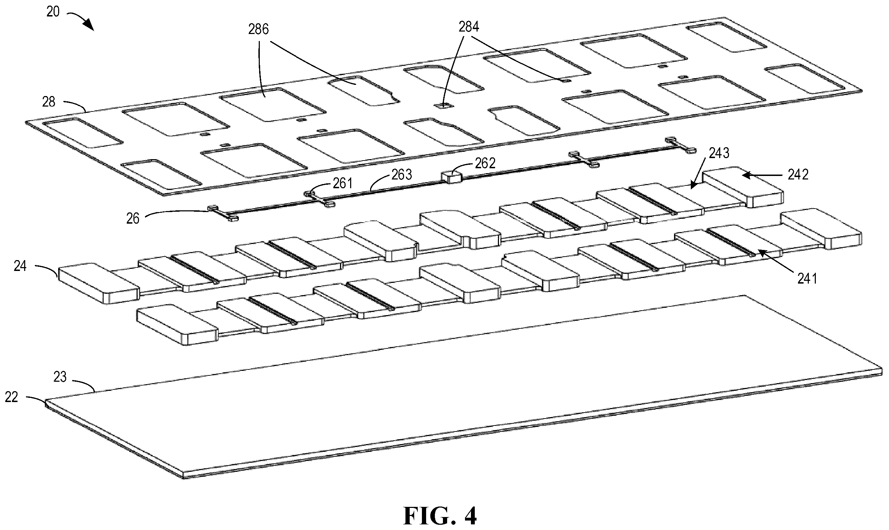

FIG. 2C illustrates a perspective view of an interconnect package 20 according to an embodiment of the present disclosure. Referring to FIG. 2C, the interconnect package 20 comprises source connecting portions 24 adapted to connect the source pads 14 to the substrate 12, and gate connecting portions 26 adapted to connect the gate pads 16 to the substrate 12. The source connecting portions 24 comprise source pad connecting portions 241 for coupling with the source pads 14 and source substrate connecting portions 242 for coupling with the substrate. The gate connecting portions 26 comprise gate pad connecting portions 261 for coupling with the gate pads 16 and gate substrate connecting portions 262 for coupling with the substrate. The structure of the interconnect package 20 is described in detail below with reference to FIG. 3 and FIG. 4.

FIG. 3A illustrates a top view of a portion of a power module 1 according to an embodiment of the present disclosure. FIG. 3B and FIG. 3C show cross-sectional views of a portion of the power module 1 shown in FIG. 3A, respectively.

A plurality of dies are bonded to the substrate 12. In the cross section taken in the A-A' direction shown in FIG. 3B, the gate pad 16 of the die is exposed from an upper surface and coupled with the gate pad connecting portion 261 of the interconnect package 20 by using a sintering paste 31. The gate substrate connecting portion 262 of the interconnect package 20 is couples with the substrate 12, and electrically connects the substrate 12 with the gate pad 16 via a conductive trace 263 of the gate connecting portion 26.

In the cross section taken in the B-B' direction shown in FIG. 3C, the source pad 14 of the die is exposed from the upper surface and coupled with the source pad connecting portion 241 of the interconnect package 20 by using the sintering paste 32. The source substrate connecting portion 242 of the interconnect package 20 is couples with the substrate 12 and electrically connects the substrate 12 with the source pad 14 via a portion 243 (see FIG. 4) of the source connecting portion 24.

FIG. 4 illustrates an exploded view of an interconnect package 20 according to a first embodiment of the present disclosure. The interconnect package 20 comprises a first insulating layer 22, a second insulating layer 28, and a source connecting portion 24 and a gate connecting portion 26 between the first insulating layer 28 and the second insulating layer 22. The first insulating layer 22 and the second insulating layer 28 are each made of an insulating material, including but not limited to polyimide, silicone, thermoplastic resin, fiberglass, or any other material having high insulating and moisture barrier properties. An insulating adhesive 23 is applied on the first insulating layer 22 to attach the first insulating layer 22 to the second insulating layer 28.

The insulating adhesive includes, but not limited to, attachment materials having insulating electrical properties such as epoxy, modified phenolic, polyurethane, anaerobic adhesives, and an inorganic adhesive. The second insulating layer 28 has a plurality of openings running therethrough. The openings running through the second insulating layer 28 include a plurality of gate openings 284 and a plurality of source openings 286. The gate opening 284 comprises openings corresponding to the gate pad connecting portion 261 and the gate substrate connecting portion 262, and the source opening 286 comprises openings corresponding to the source pad connecting portion 241 and the source substrate connecting portion 242.

The first insulating layer 22 is attached to the second insulating layer 28 via an adhesive layer 23, and sandwiches a portion 243 of the source connecting portion 24 and the conductive trace 263 of the gate connecting portion 26 in the laminated insulating layer so that the source pad connecting portion 241 and the source substrate connecting portion 242 of the source connecting portion 24 are exposed from the plurality of source openings 286, and so that the gate pad connecting portion 261 and the gate substrate connecting portion 262 are exposed from the plurality of gate openings 284.

The source connecting portion 24 is formed of a conductive sheet. The conductive sheet may be a copper sheet, an aluminum sheet or a sheet made of other metal. The pad connecting portion 241 to be coupled with the pad of the die and a portion 243 of the source connecting portion 24 are formed by patterning the conductive sheet. In some embodiments, the conductive sheet may be patterned using a photolithography technique and an etching method. It should be appreciate that the unetched portion of the conductive sheet may serve as the substrate connecting portion 241 for coupling with the substrate of the power device. In some embodiments, the substrate connecting portion 241 may be formed by etching. In other embodiments, the conductive sheet may be patterned in other manners such as etching, which will not be limited in the present disclosure.

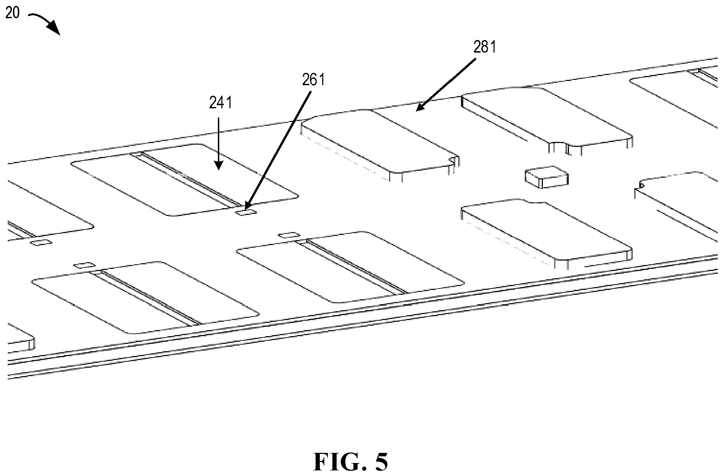

In some embodiments, the source pad connecting portion 241 is formed to have a thickness less than the source substrate connecting portion 242 and greater than the portion 243 of the conductive sheet. In this case, when the first insulating layer 22 and the second insulating layer 28 are attached, the portion 243 of the conductive sheet is embedded in the adhesive 23 on the first insulating layer 22. In some embodiments, a thickness of the source pad connecting portion 241 is equal to a depth of the source opening 286 such that a surface of the source pad connecting portion 241 is flush with an upper surface of the second insulating layer 28 after the attachment is completed, as shown in FIG. 5. FIG. 5 illustrates a partially enlarged portion of the interconnect package 20.

Returning to FIG. 4, the formation of the gate connecting portion 26 is described. In some embodiments, the gate pad connecting portion 261 and the gate substrate connecting portion 262 exposed from the gate opening 284, and the conductive trace 263 not exposed from the gate opening 284 are formed by depositing a conductive film on a lower surface of the second insulating layer 28. In this case, the gate pad connecting portion 261 and the gate substrate connecting portion 262 are exposed from a bottom end of the gate opening 284. In other embodiments, the conductive film continues to be deposited at the bottom end of the gate opening 284 on a side of the upper surface of the second insulating layer 28, and the thickness of the conductive film on the gate substrate connecting portion 262 is made larger than that of the conductive film on the gate pad connecting portion 261.

The conductive film may be a metal or metal alloy, such as aluminum, copper, platinum, gold, or any combination thereof. The conductive film may be deposited by any conventional method suitable for metals, such as sputtering, electroplating, thermal evaporation, atomic layer deposition (ALD), or chemical vapor deposition (CVD). This aspect is not limited in the present disclosure in this regard.

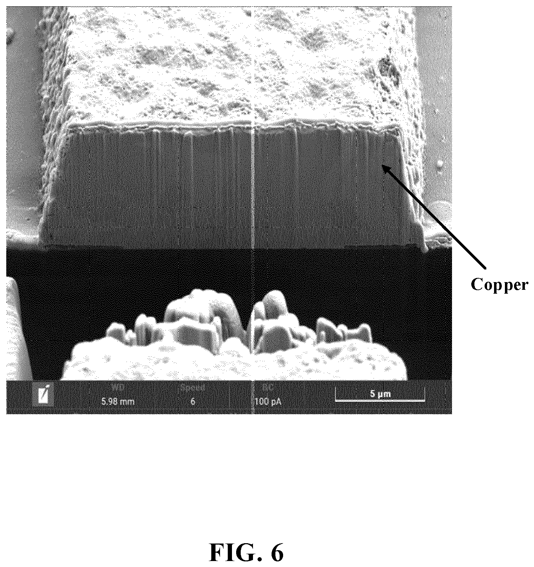

FIG. 6 illustrates a scanning electron microscope (SEM) image of a conductive film according to an embodiment of the present disclosure. In FIG. 6, a cross-sectional view of a portion of a copper film formed by growing a film is shown, taking the metal copper as an example. As can be seen, the gate connecting portion composed of the copper film is dense in the interior and has a smooth surface, and is capable of preventing a wire defect due to the aging of the molding material and improving the breakdown voltage of the device.

Referring back to FIG. 5, the surface of the gate pad connecting portion 261 is also flush with the upper surface 281 of the second insulating layer. It should be appreciated that in some embodiments, the surfaces of the gate pad connecting portion 261 and the source pad connecting portion 241 may extend beyond the upper surface of the second insulating layer 28. Then, the interconnect package 20 is attached to power device 10 via a sintering paste to effect respective interconnection of source pad 24 and gate pad 26 to the substrate 12.

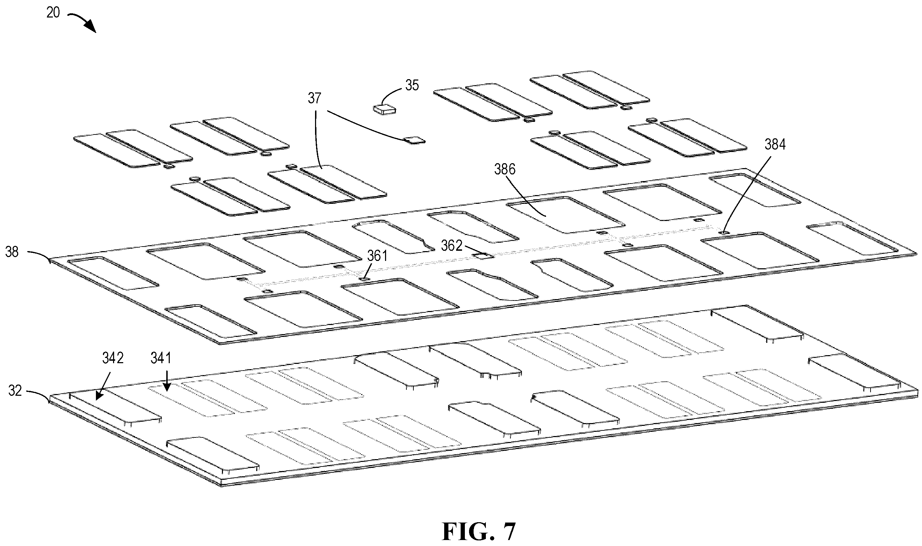

The interconnect package 30 of the second embodiment of the present disclosure is described in detail below with reference to FIG. 7. Such a structure of the interconnect package 30 is the same as or similar to the structure of interconnect package 20 shown in FIGS. 2-5. Therefore, the aspects of the interconnect package 20 described with reference to to FIGS. 2-5 may apply to interconnect package 30 of FIG. 7. In some embodiments, the structure of interconnect package 30 is similar to the interconnect package 20, except that the thickness of source pad connecting portion 341 and gate pad connecting portion 361 is less than the opening depth of the source opening 386 and the gate opening 384, respectively, as shown by the light line in FIG. 7.

In this case, the sintering paste 37 is filled in the source opening in the source opening 386 corresponding to the source pad connecting portion 341 and the gate opening in the gate opening 384 corresponding to the gate pad connecting portion 361 by means of screen printing or spraying. Further, a conductive gasket 35 is disposed at the gate opening of the gate opening 384 corresponding to the gate substrate connecting portion 362. The conductive gasket 35 is coupled with the gate substrate connecting portion 362 via the sintering paste 37, and further electrically connects the gate substrate connecting portion 362 with the substrate 12. In this manner, the interconnect package 30 may be attached to the power device 10 efficiently without the need for secondary growth of a conductive film on the upper surface of the second insulating layer 28.

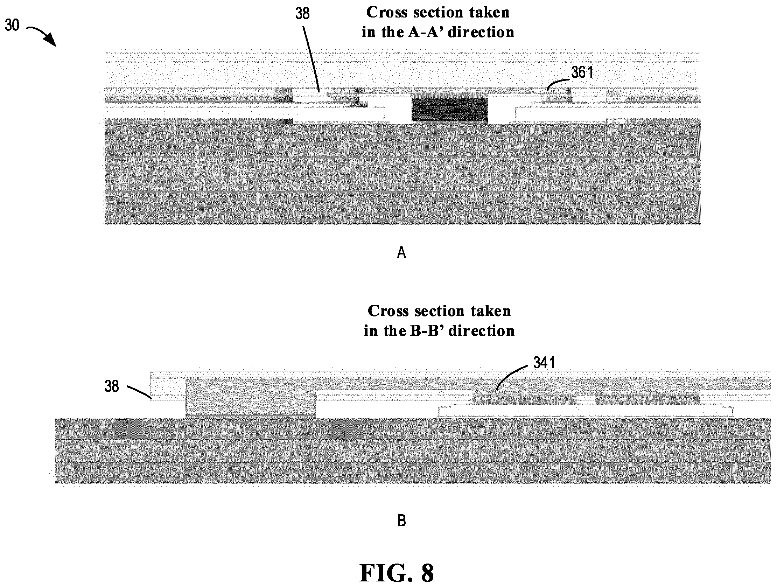

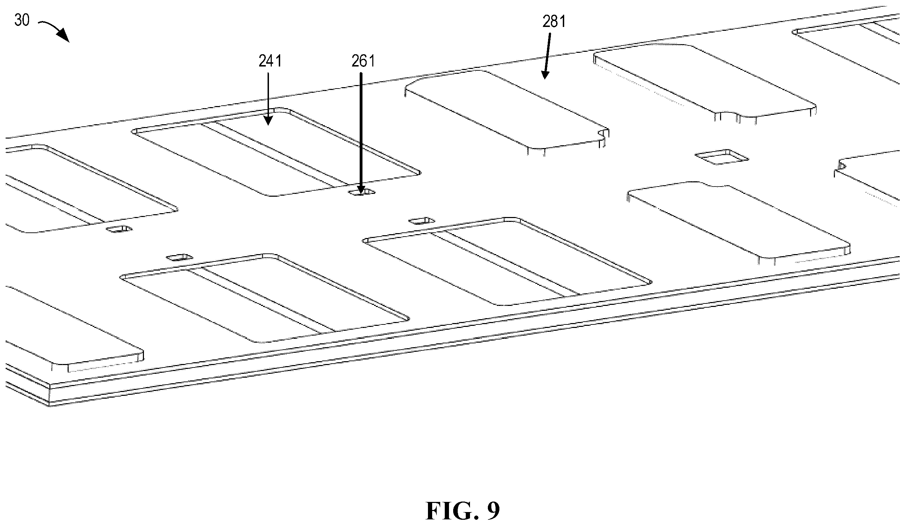

FIG. 8A and FIG. 8B illustrate cross-sectional views of the interconnect package 30 shown in FIG. 7, taken in the A-A' direction and B-B' direction, respectively. The interconnect package 30 shown in FIG. 8A and FIG. 8B differs from the interconnect package 20 shown in FIG. 3A and FIG. 3B in that the thickness of the gate pad connecting portion 361 and the source pad connecting portion 341 is smaller than the depth of the gate opening and the source opening. In other words, the surfaces of the gate pad connecting portion 361 and the source pad connecting portion 341 are not in flush with the upper surface of the second insulating layer 38. FIG. 9 illustrates an enlarged partial perspective view of the interconnect package 30 shown in FIG. 7, and the above structure can be clearly seen from FIG. 9.

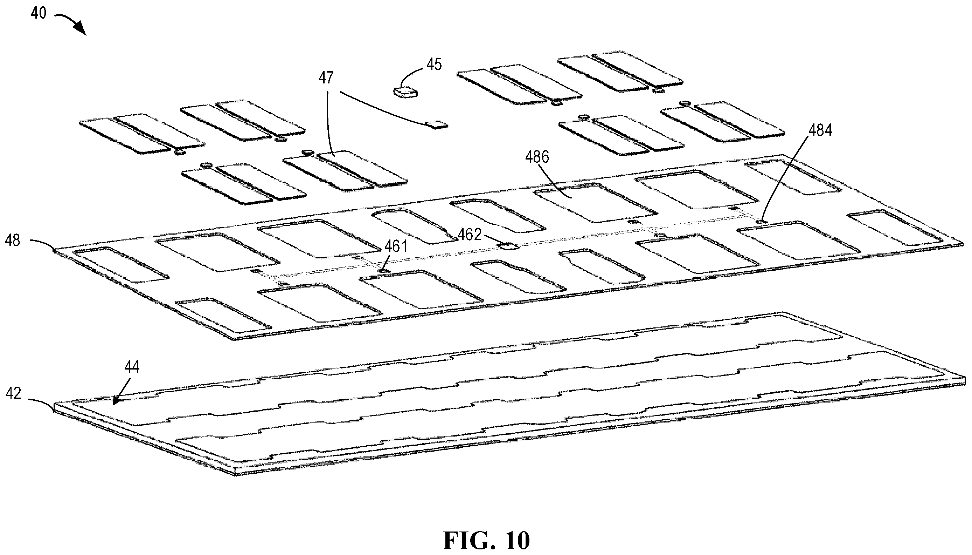

FIG. 10 illustrates an exploded view of an interconnect package 40 according to a third embodiment of the present disclosure. The structure of the interconnect package 40 in FIG. 10 is the same as or similar to that of the interconnect package 30 in FIG. 7 and, the same elements will not be described repeatedly herein. The interconnect package 40 differs from interconnect package 30 in that the source connecting portion 44 is formed directly from a conductive sheet and is not etched to form the source pad connecting portion and the source substrate connecting portion having different thicknesses. In some embodiments, the source pad connecting portion and the source substrate connecting portion have the same thickness and are both exposed from the bottom end of the source opening. The gate connecting portion 46 of the interconnect package 40 depicted with reference to FIG. 10 is the same as the gate connecting portion 36 of the interconnect package 30 in FIG. 7 in terms of the fabrication process and structure.

As described with reference to FIG. 7, the sintering paste 47 is filled in the source opening in the source opening 486 corresponding to the source pad connecting portion and the gate opening in the gate opening 484 corresponding to the gate pad connecting portion 461 by means of screen printing or spraying. Further, a conductive gasket 45 is disposed at the gate opening of the gate opening 484 corresponding to the gate substrate connecting portion 462. The conductive gasket 45 is coupled with the gate substrate connecting portion 462 via the sintering paste 47, and further electrically connects the gate substrate connecting portion 462 with the substrate 12.

Likewise, in some embodiments, an additional conductive gasket (not shown) is provided at the source opening of the source opening 486 corresponding to the source substrate connecting portion, and the additional conductive gasket is coupled with the substrate 12 via the sintering paste 47 and electrically connects the source substrate connecting portion to the substrate 12.

As such, by providing the additional conductive gasket to couple the source substrate connecting portion of the conductive sheet to the substrate, the etching process for the conductive sheet is omitted, and the production efficiency of the interconnect packages is further improved.

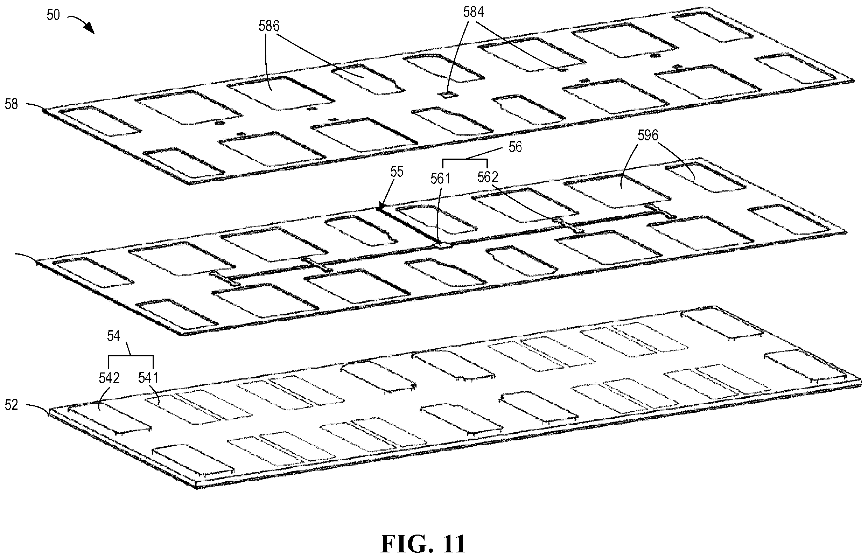

FIG. 11 illustrates an exploded view of an interconnect package 50 according to a fourth embodiment of the present disclosure. The structure of the interconnect package 50 shown in FIG. 11 is the same as or similar to that of the interconnect package 30 shown in FIG. 7 and, the same elements will not be described in detail any more herein. The interconnect package 50 differs from the interconnect package 30 in that a portion 55 of a gate connecting portion 56 overlaps a portion of a source connecting portion 54 in a vertical direction perpendicular to the surface of the interconnect package. In this case, in order to avoid breakdown of the power device when a voltage is applied, a third insulating layer 59 is interposed between a first insulating layer 52 and a second insulating layer 58 such that the gate connecting portion 56 is sandwiched between the second insulating layer 58 and the third insulating layer 59. As shown in FIG. 11, the third insulating layer 59 has a plurality of additional source openings 596 for accommodating source pad connecting portions 541 and source substrate connecting portions 542 of the source connecting portion 54.

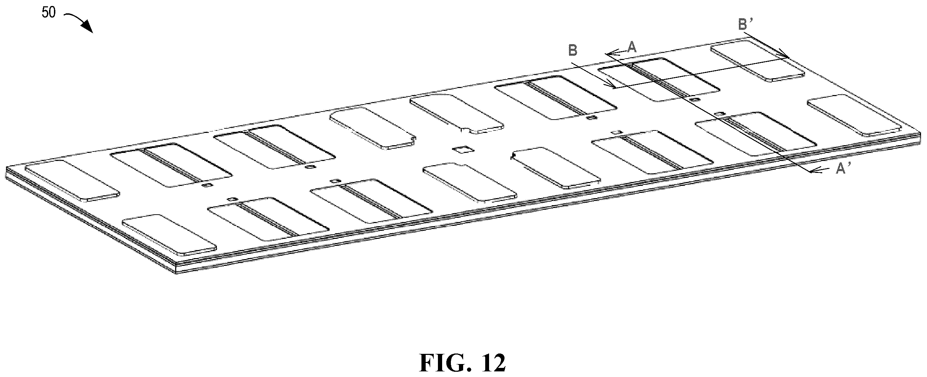

Thus, the first insulating layer 52, the second insulating layer 58 and the third insulating layer are sequentially attached to form the interconnect package 50 as shown in FIG. 12. A gate pad connecting portion 561 and a gate substrate connecting portion 562 of the gate connecting portion 56 are exposed from a gate opening 584 of the second insulating layer 58, and a portion 55 of the gate connecting portion 56 vertically overlapping the source connecting portion 54 is spaced-apart from the source connecting portion 54 via the third insulating layer 59. In some embodiments, the gate connecting portion 56 is formed on the upper surface of the third insulating layer 59 by growing a conductive film. It should be appreciated that the gate connecting portion 56 may also grow on a lower surface of the second insulating layer 58 in the same manner as the previous embodiments. As such, the power module 1 may still be operated with excellent performance even if the gate connecting portion 56 partially overlaps the source connecting portion 54 in the vertical direction when the wiring layout is optimized.

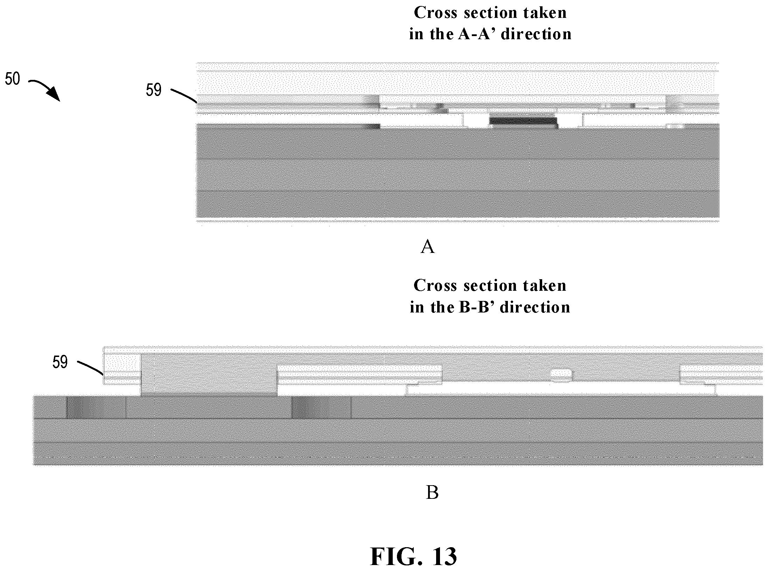

FIG. 13 illustrates cross-sectional views of the interconnect package 50 shown in FIG. 12, taken in the A-A' direction and B-B' direction, respectively. The interconnect package 50 shown in FIG. 13A and FIG. 13B differs from the interconnect package 30 shown in FIG. 8A and FIG. 8B in that a portion 55 of the gate connecting portion 56 overlaps the source connecting portion 54 in the vertical direction. This portion 55 of the gate connecting portion 56 is spaced-apart from the source connecting portion 54 by the third insulating layer 59 so that the power device is less prone to breakdown during operation.

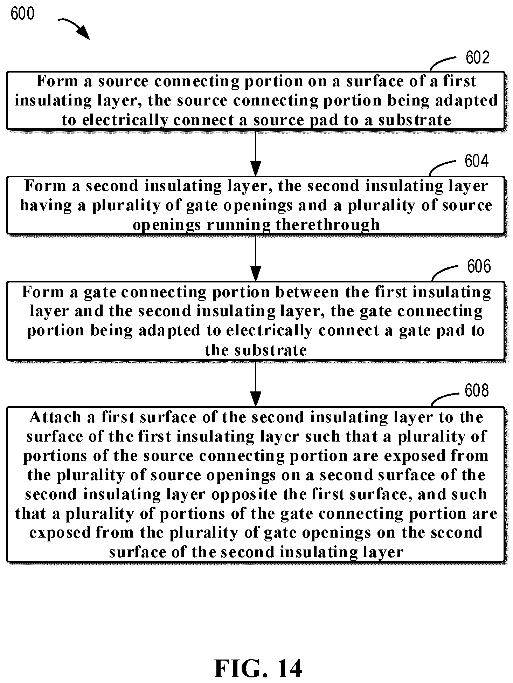

FIG. 14 illustrates a flow chart of a process 600 for preparing the interconnect package 20 according to an embodiment of the present disclosure. The flow 600 is described below with reference to FIG. 2 and FIG. 4.

At block 602, the source connecting portion 24 is formed on the first insulating layer 22 via the insulating adhesive 23. The source connecting portion 24 is adapted to electrically connect the source pad to the substrate. The source connecting portion 24 comprises the source pad connecting portion 241 for coupling with the source pad 14, and the source substrate connecting portion 242 for coupling with the substrate 12. The specific process of forming the source connecting portion 24 is introduced in detail in the depictions with reference to FIG. 4 and will not be described in detail any more herein.

At block 604, the second insulating layer 28 is formed having a plurality of gate openings 284 and a plurality of source openings 288 therethrough. The gate opening 284 and source opening 286 are adapted to receive the gate connecting portion 26 (see block 606) and the source connecting portion 24, respectively.

At block 606, the gate pad connecting portion 261 and the gate substrate connecting portion 262 exposed from the gate opening 284, and the conductive trace 263 not exposed from the gate opening 284 are formed by depositing a conductive film on the lower surface of the second insulating layer 28. In some embodiments, the conductive film continues to be deposited in the gate opening on a side of the upper surface of the second insulating layer 28 such that the thickness of the conductive film on the gate substrate connecting portion 262 is greater than the that of the conductive film on the gate pad connecting portion 261. The method and material for forming the conductive film are the same as or similar to those described above with reference to FIG. 4, and will not be described in detail herein.

At block 608, the lower surface of the second insulating layer 208 is attached to the surface of the first insulating layer 22 such that a plurality of portions of the source connecting portion 24 are exposed from the plurality of source openings 286 on the upper surface of the second insulating layer opposite the lower surface and such that a plurality of portions of the gate connecting portion 26 are exposed from the plurality of gate openings 284 on the upper surface of the second insulating layer 28.

It should be appreciated that the process described above may be performed in any reasonable order, either sequentially or in parallel.

It should also be appreciated that the interconnect packages produced by the above process may be used for example in a power module such as an electronic control unit in an automotive system. In certain embodiments, the power module may include at least one interconnect package as described in the above embodiments and combinations thereof.

Although the subject matter has been described in language specific to structural features, it is to be understood that the subject matter defined in the appended claims is not necessarily limited to the specific features or acts described above. Rather, the specific features and acts described above are merely exemplary forms of implementing the claims.

Without prejudice to the underlying principles, the details and embodiments may vary, even significantly, with respect to what has been described by way of example only, without departing from the scope of protection.

## Claims

1. An interconnect package (20; 30; 40; 50), adapted to be attached to a power device (10), comprising:
a first insulating layer (22, 32, 42, 52);
a source connecting portion (24, 34, 44, 54) disposed on a surface of the first insulating layer and adapted to electrically connect a source pad (14) to a substrate (12) of the power device (10);
a second insulating layer (28, 38, 48, 58) having a plurality of gate openings (284, 384, 484, 584) and a plurality of source openings (286, 386, 486, 596) running through the second insulating layer;
a gate connecting portion (26, 36, 46, 56) adapted to electrically connect a gate pad to the substrate and located between the first insulating layer and the second insulating layer; and
wherein a first surface of the second insulating layer is configured to attach to the surface of the first insulating layer such that a plurality of portions of the source connecting portion are exposed from the plurality of source openings on a second surface of the second insulating layer opposite the first surface, and such that a plurality of portions of the gate connecting portion are exposed from the plurality of gate openings on the second surface of the second insulating layer;
wherein the first insulating layer is attached to the second insulating layer via an adhesive layer (23);
wherein the source connecting portion (24, 34, 44, 54) is formed by a conductive sheet,
wherein the plurality of portions of the source connecting portion comprise a source pad connecting portion for coupling with the source pad and a source substrate connecting portion for coupling with the substrate, and
wherein the source pad connecting portion is electrically connected with the source substrate connecting portion via a portion of the conductive sheet not exposed from the plurality of source openings.

2. The interconnect package according to claim 1, wherein the plurality of portions of the gate connecting portion (26, 36, 46, 56) exposed from bottom ends of the plurality of gate openings, and conductive traces not exposed from the plurality of gate openings are formed by depositing a conductive film on the first surface of the second insulating layer,
wherein the plurality of portions of the gate connecting portion (26, 36, 46, 56) comprise a gate pad connecting portion for coupling with the gate pad and a gate substrate connecting portion for coupling with the substrate, and
wherein the conductive trace electrically connects the gate pad connecting portion with the gate substrate connecting portion.

3. The interconnect package according to claim 2, wherein the source pad connecting portion and the source substrate connecting portion are formed by patterning the conductive sheet, and
wherein a thickness of the source pad connecting portion is less than that of the source substrate connecting portion and greater than that of the portion of the conductive sheet.

4. The interconnect package according to claim 3, wherein the thickness of the source pad connecting portion (341) is less than a depth of the plurality of source openings (386).

5. The interconnect package according to claim 3, wherein the thickness of the source pad connecting portion is greater than or equal to a depth of the source opening.

6. The interconnect package according to claim 2, wherein the source substrate connecting portion (486) is electrically connected to the substrate through a conductive gasket.

7. The interconnect package according to claim 4 or 6, wherein the gate substrate connecting portion is coupled to the substrate through a conductive gasket.

8. The interconnect package according to claim 5, wherein a second conductive film is deposited at the bottom ends of the plurality of gate openings such that a portion of the second conductive film on the gate substrate connecting portion has a thickness greater than that of a portion of the second conductive film on the gate pad portion.

9. The interconnect package according to any of the preceding claims, wherein the interconnect package further comprises a third insulating layer (59) located between the first insulating layer and the gate connecting portion and comprising the plurality of source openings running through the third insulating layer.

10. A method of forming an interconnect package (20, 30, 40, 50), adapted to be attached to a power device (10), comprising:
forming (602) a source connecting portion on a surface of a first insulating layer, the source connecting portion being adapted to electrically connect a source pad to a substrate of the power device;
forming (604) a second insulating layer, the second insulating layer having a plurality of gate openings and a plurality of source openings running therethrough;
forming (606) a gate connecting portion between the first insulating layer and the second insulating layer, the gate connecting portion being adapted to electrically connect a gate pad to the substrate; and
attaching (608) a first surface of the second insulating layer to the surface of the first insulating layer such that a plurality of portions of the source connecting portion are exposed from the plurality of source openings on a second surface of the second insulating layer opposite the first surface, and such that a plurality of portions of the gate connecting portion are exposed from the plurality of gate openings on the second surface of the second insulating layer;
wherein the first insulating layer is attached by the second insulating layer by a insulating adhesive (23);
wherein forming the source connecting portion comprises forming the source connecting portion by a conductive sheet,
wherein the plurality of portions of the source connecting portion comprise a source pad connecting portion for coupling with the source pad, and a source substrate connecting portion for coupling with the substrate, and
wherein the source pad connecting portion is electrically connected with the source substrate connecting portion via a portion of the conductive sheet not exposed from the plurality of source openings.

11. The method according to claim 10, wherein forming (606) the gate connecting portion comprises depositing a conductive film on the first surface of the second insulating layer, to form the plurality of portions of the gate connecting portion exposed from bottom ends of the plurality of gate openings, and conductive traces not exposed from the plurality of gate openings,
wherein the plurality of portions of the gate connecting portion comprise a gate pad connecting portion for coupling with the gate pad and a gate substrate connecting portion for coupling with the substrate, and
wherein the conductive trace electrically connects the gate pad connecting portion with the gate substrate connecting portion.

12. The method according to claim 10, wherein forming the source connecting portion further comprises:
forming the source pad connecting portion and the source substrate connecting portion by patterning the conductive sheet, and
wherein a thickness of the source pad connecting portion is less than a thickness of the source substrate connecting portion and greater than a thickness of the portion of the conductive sheet.

13. The method according to claim 12, wherein the source pad connecting portion is formed as having a thickness less than a depth of the plurality of source openings.

14. The method according to claim 12, wherein the source pad connecting portion is formed as having a thickness greater than or equal to a depth of the plurality of source openings.

15. The method according to claim 10, wherein the source substrate connecting portion is electrically connected to the substrate through a conductive gasket.

16. The method according to claim 13 or 15, wherein the gate substrate connecting portion is coupled to the substrate through a conductive gasket.

17. The method according to claim 14, wherein forming the gate connecting portion further comprises: depositing a second conductive film at the bottom ends of the plurality of gate openings such that a portion of the second conductive film on the gate substrate connecting portion has a thickness greater than that of a portion of the second conductive film on the gate pad portion.

18. The method according to claim 13, further comprising filling an adhesive in the source opening in the plurality of source openings corresponding to the source pad connecting portion and the gate opening in the plurality of gate openings corresponding to the gate pad connecting portion by means of screen printing or spraying.

19. The method according to any of the preceding claims, further comprising forming a third insulating layer located between the first insulating layer and the gate connecting portion, the insulating layer comprising the plurality of source openings running through the third insulating layer.

20. A power module, comprising:
a substrate (12);
a die disposed on the substrate and including a source pad (14) and a gate pad (16);
the interconnect package (20; 30; 40; 50) according to any of claims 1-9, the interconnect package covering the die and used for electrically connecting the source pad and the gate pad of the die to the substrate, respectively.

21. The power module according to claim 20, wherein the interconnect package is attached to the substrate by an adhesive.

22. The power module according to claim 20, further comprising a mold material for encapsulating the substrate, the die, and the interconnect package together.

## Patentansprüche

1. Verbindungspaket (20; 30; 40; 50), das angepasst ist, um an einer Leistungsvorrichtung (10) angebracht zu werden, umfassend:
eine erste Isolierschicht (22, 32, 42, 52);
einen Source-Verbindungsabschnitt (24, 34, 44, 54), der auf einer Oberfläche der ersten Isolierschicht angeordnet und angepasst ist, um ein Source-Pad (14) elektrisch mit einem Substrat (12) der Leistungsvorrichtung (10) zu verbinden;
eine zweite Isolierschicht (28, 38, 48, 58), die eine Vielzahl von Gate-Öffnungen (284, 384, 484, 584) und eine Vielzahl von Source-Öffnungen (286, 386, 486, 596) aufweist, die durch die zweite Isolierschicht verlaufen;
einen Gate-Verbindungsabschnitt (26, 36, 46, 56), der angepasst ist, um ein Gate-Pad elektrisch mit dem Substrat zu verbinden und sich zwischen der ersten Isolierschicht und der zweiten Isolierschicht befindet; und
wobei eine erste Oberfläche der zweiten Isolierschicht konfiguriert ist, um an der Oberfläche der ersten Isolierschicht angebracht zu werden, sodass eine Vielzahl von Abschnitten des Source-Verbindungsabschnitts von der Vielzahl von Source-Öffnungen auf einer zweiten Oberfläche der zweiten Isolierschicht gegenüber der ersten Oberfläche freiliegen, und sodass eine Vielzahl von Abschnitten des Gate-Verbindungsabschnitts von der Vielzahl von Gate-Öffnungen auf der zweiten Oberfläche der zweiten Isolierschicht freiliegen;
wobei die erste Isolierschicht über eine Klebeschicht (23) an der zweiten Isolierschicht angebracht ist;
wobei der Source-Verbindungsabschnitt (24, 34, 44, 54) durch ein leitfähiges Blech gebildet ist,
wobei die Vielzahl von Abschnitten des Source-Verbindungsabschnitts einen Source-Pad-Verbindungsabschnitt zum Koppeln mit dem Source-Pad und einen Source-Substratverbindungsabschnitt zum Koppeln mit dem Substrat umfassen, und
wobei der Source-Pad-Verbindungsabschnitt über einen Abschnitt des leitfähigen Blechs, der nicht von der Vielzahl von Source-Öffnungen freiliegt, elektrisch mit dem Source-Substrat-Verbindungsabschnitt verbunden ist.

2. Verbindungspaket nach Anspruch 1, wobei die Vielzahl von Abschnitten des Gate-Verbindungsabschnitts (26, 36, 46, 56), die von den unteren Enden der Vielzahl von Gate-Öffnungen freigelegt sind, und leitfähige Spuren, die nicht von der Vielzahl von Gate-Öffnungen freigelegt sind, durch Abscheiden eines leitfähigen Films auf der ersten Oberfläche der zweiten Isolierschicht gebildet werden, wobei die Vielzahl von Abschnitten des Gate-Verbindungsabschnitts (26, 36, 46, 56) einen Gate-Pad-Verbindungsabschnitt zum Koppeln mit dem Gate-Pad und einen Gate-Substrat-Verbindungsabschnitt zum Koppeln mit dem Substrat umfassen, und
wobei die leitfähige Spur den Gate-Pad-Verbindungsabschnitt elektrisch mit dem des Gate-Substrat-Verbindungsabschnitt verbindet.

3. Verbindungspaket nach Anspruch 2, wobei der Source-Pad-Verbindungsabschnitt und der Source-Substrat-Verbindungsabschnitt durch Mustern des leitfähigen Blechs gebildet sind, und
wobei eine Dicke des Source-Pad-Verbindungsabschnitts kleiner als jene des Source-Substrat-Verbindungsabschnitts und größer als jene des Abschnitts des leitfähigen Blechs ist.

4. Verbindungspaket nach Anspruch 3, wobei die Dicke des Source-Pad-Verbindungsabschnitts (341) geringer ist als eine Tiefe der Vielzahl von Source-Öffnungen (386).

5. Verbindungspaket nach Anspruch 3, wobei die Dicke des Source-Pad-Verbindungsabschnitts größer oder gleich einer Tiefe der Source-Öffnung ist.

6. Verbindungspaket nach Anspruch 2, wobei der Source-Substrat-Verbindungsabschnitt (486) durch eine leitfähige Dichtung elektrisch mit dem Substrat verbunden ist.

7. Verbindungspaket nach Anspruch 4 oder 6, wobei der Gate-Substrat-Verbindungsabschnitt durch eine leitfähige Dichtung mit dem Substrat gekoppelt ist.

8. Verbindungspaket nach Anspruch 5, wobei ein zweiter leitfähiger Film an den unteren Enden der Vielzahl von Gate-Öffnungen abgelegt ist, sodass ein Abschnitt des zweiten leitfähigen Films auf dem Gate-Substrat-Verbindungsabschnitt eine Dicke aufweist, die größer ist als jene eines Abschnitts des zweiten leitfähigen Films auf dem Gate-Pad-Abschnitt.

9. Verbindungspaket nach einem der vorstehenden Ansprüche, wobei das Verbindungspaket ferner eine dritte Isolierschicht (59) umfasst, die sich zwischen der ersten Isolierschicht und dem Gate-Verbindungsabschnitt befindet und die Vielzahl von Source-Öffnungen umfasst, die durch die dritte Isolierschicht verlaufen.

10. Verfahren zum Bilden eines Verbindungspakets (20, 30, 40, 50), das angepasst ist, um an einer Leistungsvorrichtung (10) angebracht zu werden, umfassend:
Bilden (602) eines Source-Verbindungsabschnitts auf einer Oberfläche einer ersten Isolierschicht, wobei der Source-Verbindungsabschnitt angepasst ist, um ein Source-Pad elektrisch mit einem Substrat der Leistungsvorrichtung zu verbinden;
Bilden (604) einer zweiten Isolierschicht, wobei die zweite Isolierschicht eine Vielzahl von Gate-Öffnungen und eine Vielzahl von Source-Öffnungen aufweist, die dort hindurch verlaufen;
Bilden (606) eines Gate-Verbindungsabschnitts zwischen der ersten Isolierschicht und der zweiten Isolierschicht, wobei der Gate-Verbindungsabschnitt angepasst ist, um ein Gate-Pad elektrisch mit dem Substrat zu verbinden; und
Anbringen (608) einer ersten Oberfläche der zweiten Isolierschicht an der Oberfläche der ersten Isolierschicht, sodass eine Vielzahl von Abschnitten des Source-Verbindungsabschnitts von der Vielzahl von Source-Öffnungen auf einer zweiten Oberfläche der zweiten Isolierschicht gegenüber der ersten Oberfläche freiliegen, und sodass eine Vielzahl von Abschnitten des Gate-Verbindungsabschnitts von der Vielzahl von Gate-Öffnungen auf der zweiten Oberfläche der zweiten Isolierschicht freiliegen;
wobei die erste Isolierschicht durch einen isolierenden Klebstoff (23) an der zweiten Isolierschicht angebracht ist;
wobei das Bilden des Source-Verbindungsabschnitts das Bilden des Source-Verbindungsabschnitts durch ein leitfähiges Blech umfasst,
wobei die Vielzahl von Abschnitten des Source-Verbindungsabschnitts einen Source-Pad-Verbindungsabschnitt zum Koppeln mit dem Source-Pad und einen Source-Substrat-Verbindungsabschnitt zum Koppeln mit dem Substrat umfassen, und
wobei der Source-Pad-Verbindungsabschnitt über einen Abschnitt des leitfähigen Blechs, der nicht von der Vielzahl von Source-Öffnungen freiliegt, elektrisch mit dem Source-Substrat-Verbindungsabschnitt verbunden ist.

11. Verfahren nach Anspruch 10, wobei das Bilden (606) des Gate-Verbindungsabschnitts das Abscheiden eines leitfähigen Films auf der ersten Oberfläche der zweiten Isolierschicht umfasst, um die Vielzahl von Abschnitten des Gate-Verbindungsabschnitts zu bilden, die von den unteren Enden der Vielzahl von Gate-Öffnungen freigelegt sind, und leitfähige Spuren, die von der Vielzahl von Gate-Öffnungen nicht freigelegt sind,
wobei die Vielzahl von Abschnitten des Gate-Verbindungsabschnitts einen Gate-Pad-Verbindungsabschnitt zum Koppeln mit dem Gate-Pad und einen Gate-Substrat-Verbindungsabschnitt zum Koppeln mit dem Substrat umfassen, und
wobei die leitfähige Spur den Gate-Pad-Verbindungsabschnitt elektrisch mit dem des Gate-Substrat-Verbindungsabschnitt verbindet.

12. Verfahren nach Anspruch 10, wobei das Bilden des Source-Verbindungsabschnitts ferner Folgendes umfasst:
Bilden des Source-Pad-Verbindungsabschnitts und des Source-Substrat-Verbindungsabschnitts durch Mustern des leitfähigen Films, und
wobei eine Dicke des Source-Pad-Verbindungsabschnitts kleiner als eine Dicke des Source-Substrat-Verbindungsabschnitts und größer als eine Dicke des Abschnitts des leitfähigen Films ist.

13. Verfahren nach Anspruch 12, wobei der Source-Pad-Verbindungsabschnitt gebildet ist, um eine Dicke aufzuweisen, die geringer ist als eine Tiefe der Vielzahl von Source-Öffnungen.

14. Verfahren nach Anspruch 12, wobei der Source-Pad-Verbindungsabschnitt gebildet ist, um eine Dicke aufzuweisen, die größer oder gleich einer Tiefe der Vielzahl von Source-Öffnungen ist.

15. Verfahren nach Anspruch 10, wobei der Source-Substrat-Verbindungsabschnitt über eine leitfähige Dichtung elektrisch mit dem Substrat verbunden ist.

16. Verfahren nach Anspruch 13 oder 15, wobei der Gate-Substrat-Verbindungsabschnitt durch eine leitfähige Dichtung mit dem Substrat gekoppelt ist.

17. Verfahren nach Anspruch 14, wobei Bilden des Gate-Verbindungsabschnitts ferner Folgendes umfasst: Ablegen eines zweiten leitfähigen Films an den unteren Enden der Vielzahl von Gate-Öffnungen, sodass ein Abschnitt des zweiten leitfähigen Films auf dem Gate-Substrat-Verbindungsabschnitt eine Dicke aufweist, die größer ist als jene eines Abschnitts des zweiten leitfähigen Films auf dem Gate-Pad-Abschnitt.

18. Verfahren nach Anspruch 13, ferner umfassend das Füllen eines Klebstoffs in die Source-Öffnung in der Vielzahl von Source-Öffnungen, die dem Source-Pad-Verbindungsabschnitt entsprechen, und die Gate-Öffnung in der Vielzahl von Gate-Öffnungen, die dem Gate-Pad-Verbindungsabschnitt entsprechen, mittels Siebdruck oder Sprühen.

19. Verfahren nach einem der vorstehenden Ansprüche, ferner umfassend das Bilden einer dritten Isolierschicht, die sich zwischen der ersten Isolierschicht und dem Gate-Verbindungsabschnitts befindet, wobei die Isolierschicht die Vielzahl von durch die dritte Isolierschicht verlaufenden Source-Öffnungen umfasst.

20. Leistungsmodul, umfassend:
ein Substrat (12);
eine Matrize, die auf dem Substrat angeordnet ist und ein Source-Pad (14) und ein Gate-Pad (16) beinhaltet;
das Verbindungspaket (20; 30; 40; 50) nach einem der Ansprüche 1-9, wobei das Verbindungspaket die Matrize abdeckt und zum elektrischen Verbinden jeweils des Source-Pads und des Gate-Pads der Matrize mit dem Substrat verwendet wird.

21. Leistungsmodul nach Anspruch 20, wobei das Verbindungspaket durch einen Klebstoff an dem Substrat angebracht ist.

22. Leistungsmodul nach Anspruch 20, ferner umfassend ein Formmaterial zum Einkapseln des Substrats, der Matrize und des Verbindungspakets zusammen.

## Revendications

1. Module d'interconnexion (20 ; 30 ; 40 ; 50), adapté pour être fixé à un dispositif d'alimentation (10), comprenant :
une première couche isolante (22, 32, 42, 52) ;
une partie de connexion de source (24, 34, 44, 54) disposée sur une surface de la première couche isolante et adaptée pour connecter électriquement un plot de source (14) à un substrat (12) du dispositif d'alimentation (10) ;
une deuxième couche isolante (28, 38, 48, 58) ayant une pluralité d'ouvertures de grille (284, 384, 484, 584) et une pluralité d'ouvertures de source (286, 386, 486, 596) traversant la deuxième couche isolante ;
une partie de connexion de grille (26, 36, 46, 56) adaptée pour connecter électriquement un plot de grille au substrat et située entre la première couche isolante et la deuxième couche isolante ; et
dans lequel une première surface de la deuxième couche isolante est configurée pour se fixer à la surface de la première couche isolante de sorte qu'une pluralité de parties de la partie de connexion de source soient exposées à partir de la pluralité d'ouvertures de source sur une seconde surface de la deuxième couche isolante opposée à la première surface, et de sorte qu'une pluralité de parties de la partie de connexion de grille soient exposées à partir de la pluralité d'ouvertures de grille sur la seconde surface de la deuxième couche isolante ;
dans lequel la première couche isolante est fixée à la deuxième couche isolante via une couche adhésive (23) ;
dans lequel la partie de connexion de source (24, 34, 44, 54) est formée par une feuille conductrice,
dans lequel la pluralité de parties de la partie de connexion de source comprend une partie de connexion de plot de source pour le couplage avec le plot de source et une partie de connexion de substrat de source pour le couplage avec le substrat, et
dans lequel la partie de connexion de plot de source est connectée électriquement à la partie de connexion de substrat de source via une partie de la feuille conductrice non exposée à partir de la pluralité d'ouvertures de source.

2. Module d'interconnexion selon la revendication 1, dans lequel la pluralité de parties de la partie de connexion de grille (26, 36, 46, 56) exposées à partir d'extrémités inférieures de la pluralité d'ouvertures de grille, et des pistes conductrices non exposées à partir de la pluralité d'ouvertures de grille sont formées en déposant un film conducteur sur la première surface de la deuxième couche isolante,
dans lequel la pluralité de parties de la partie de connexion de grille (26, 36, 46, 56) comprend une partie de connexion de plot de grille pour le couplage avec le plot de grille et une partie de connexion de substrat de grille pour le couplage avec le substrat, et
dans lequel la piste conductrice connecte électriquement la partie de connexion de plot de grille à la partie de connexion de substrat de grille.

3. Module d'interconnexion selon la revendication 2, dans lequel la partie de connexion de plot de source et la partie de connexion de substrat de source sont formées en formant des motifs sur la feuille conductrice, et
dans lequel une épaisseur de la partie de connexion de plot de source est inférieure à celle de la partie de connexion de substrat de source et supérieure à celle de la partie de la feuille conductrice.

4. Module d'interconnexion selon la revendication 3, dans lequel l'épaisseur de la partie de connexion de plot de source (341) est inférieure à une profondeur de la pluralité d'ouvertures de source (386).

5. Module d'interconnexion selon la revendication 3, dans lequel l'épaisseur de la partie de connexion de plot de source est supérieure ou égale à une profondeur de l'ouverture de source.

6. Module d'interconnexion selon la revendication 2, dans lequel la partie de connexion de substrat de source (486) est connectée électriquement au substrat par l'intermédiaire d'un joint conducteur.

7. Module d'interconnexion selon la revendication 4 ou 6, dans lequel la partie de connexion de substrat de grille est couplée au substrat par l'intermédiaire d'un joint conducteur.

8. Module d'interconnexion selon la revendication 5, dans lequel un second film conducteur est déposé aux extrémités inférieures de la pluralité d'ouvertures de grille de sorte qu'une partie du second film conducteur sur la partie de connexion de substrat de grille ait une épaisseur supérieure à celle d'une partie du second film conducteur sur la partie de plot de grille.

9. Module d'interconnexion selon l'une quelconque des revendications précédentes, dans lequel le module d'interconnexion comprend en outre une troisième couche isolante (59) située entre la première couche isolante et la partie de connexion de grille et comprenant la pluralité d'ouvertures de source traversant la troisième couche isolante.

10. Procédé de formation d'un module d'interconnexion (20, 30, 40, 50), adapté pour être fixé à un dispositif d'alimentation (10), comprenant :
la formation (602) d'une partie de connexion de source sur une surface d'une première couche isolante, la partie de connexion de source étant adaptée pour connecter électriquement un plot de source à un substrat du dispositif d'alimentation ;
la formation (604) d'une deuxième couche isolante, la deuxième couche isolante ayant une pluralité d'ouvertures de grille et une pluralité d'ouvertures de source traversant celle-ci ;
la formation (606) d'une partie de connexion de grille entre la première couche isolante et la deuxième couche isolante, la partie de connexion de grille étant adaptée pour connecter électriquement un plot de grille au substrat ; et
la fixation (608) d'une première surface de la deuxième couche isolante à la surface de la première couche isolante de sorte qu'une pluralité de parties de la partie de connexion de source est exposée à partir de la pluralité d'ouvertures de source sur une seconde surface de la deuxième couche isolante opposée à la première surface, et de sorte qu'une pluralité de parties de la partie de connexion de grille est exposée à partir de la pluralité d'ouvertures de grille sur la seconde surface de la deuxième couche isolante ;
dans lequel la première couche isolante est fixée par la deuxième couche isolante par un adhésif isolant (23) ;
dans lequel la formation de la partie de connexion de source comprend la formation de la partie de connexion de source par une feuille conductrice,
dans lequel la pluralité de parties de la partie de connexion de source comprend une partie de connexion de plot de source pour le couplage avec le plot de source, et une partie de connexion de substrat de source pour le couplage avec le substrat, et
dans lequel la partie de connexion de plot de source est connectée électriquement à la partie de connexion de substrat de source via une partie de la feuille conductrice non exposée à partir de la pluralité d'ouvertures de source.

11. Procédé selon la revendication 10, dans lequel la formation (606) de la partie de connexion de grille comprend le dépôt d'un film conducteur sur la première surface de la deuxième couche isolante, pour former la pluralité de parties de la partie de connexion de grille exposées à partir d'extrémités inférieures de la pluralité d'ouvertures de grille, et des pistes conductrices non exposées à partir de la pluralité d'ouvertures de grille,
dans lequel la pluralité de parties de la partie de connexion de grille comprend une partie de connexion de plot de grille pour le couplage avec le plot de grille et une partie de connexion de substrat de grille pour le couplage avec le substrat, et
dans lequel la piste conductrice connecte électriquement la partie de connexion de plage d'accueil de grille à la partie de connexion de substrat de grille.

12. Procédé selon la revendication 10, dans lequel la formation de la partie de connexion de source comprend en outre :
la formation de la partie de connexion de plot de source et de la partie de connexion de substrat de source en formant des motifs sur la feuille conductrice, et
dans lequel une épaisseur de la partie de connexion de plot de source est inférieure à une épaisseur de la partie de connexion de substrat de source et supérieure à une épaisseur de la partie de la feuille conductrice.

13. Procédé selon la revendication 12, dans lequel la partie de connexion de plot de source est formée comme ayant une épaisseur inférieure à une profondeur de la pluralité d'ouvertures de source.

14. Procédé selon la revendication 12, dans lequel la partie de connexion de plot de source est formée comme ayant une épaisseur supérieure ou égale à une profondeur de la pluralité d'ouvertures de source.

15. Procédé selon la revendication 10, dans lequel la partie de connexion de substrat de source est connectée électriquement au substrat par l'intermédiaire d'un joint conducteur.

16. Procédé selon la revendication 13 ou 15, dans lequel la partie de connexion de substrat de grille est couplée au substrat par l'intermédiaire d'un joint conducteur.

17. Procédé selon la revendication 14, dans lequel la formation de la partie de connexion de grille comprend en outre : le dépôt d'un second film conducteur aux extrémités inférieures de la pluralité d'ouvertures de grille de sorte qu'une partie du second film conducteur sur la partie de connexion de substrat de grille ait une épaisseur supérieure à celle d'une partie du second film conducteur sur la partie de plot de grille.

18. Procédé selon la revendication 13, comprenant en outre le remplissage avec un adhésif de l'ouverture de source dans la pluralité d'ouvertures de source correspondant à la partie de connexion de plot de source et l'ouverture de grille dans la pluralité d'ouvertures de grille correspondant à la partie de connexion de plot de grille au moyen d'une sérigraphie ou d'une pulvérisation.

19. Procédé selon l'une quelconque des revendications précédentes, comprenant en outre la formation d'une troisième couche isolante située entre la première couche isolante et la partie de connexion de grille, la couche isolante comprenant la pluralité d'ouvertures de source traversant la troisième couche isolante.

20. Module d'alimentation, comprenant :
un substrat (12) ;
une puce disposée sur le substrat et comportant un plot de source (14) et un plot de grille (16) ;
le module d'interconnexion (20 ; 30 ; 40 ; 50) selon l'une quelconque des revendications 1 à 9, le module d'interconnexion couvrant la puce et étant utilisé pour connecter électriquement le plot de source et le plot de grille du dé au substrat, respectivement.

21. Module d'alimentation selon la revendication 20, dans lequel le module d'interconnexion est fixé au substrat par un adhésif.

22. Module d'alimentation selon la revendication 20, comprenant en outre un matériau de moule pour encapsuler le substrat, la puce et le module d'interconnexion ensemble.
